# EUROPÄISCHE PATENTANMELDUNG

(11) **EP 3 279 956 A1**
(43) Veröffentlichungstag der Anmeldung: **07.02.2018**
(21) Anmeldenummer: 17180529.4
(22) Anmeldetag: 10.07.2017
(51) Int. Cl.: H01L 43/06, H01L 21/02, H01L 43/10, H01L 43/14, H01L 29/16, C01B 32/182, H01L 51/00

(54) **VERFAHREN ZUM HERSTELLEN EINES SCHICHTSTAPELS UND/ODER EINER TOPOLOGIE, SCHICHTSTAPEL UND VERFAHREN ZUM ERFASSEN EINES MAGNETFELDS**

(30) Priorität: 05.08.2016 DE 102016214573
(71) Anmelder: Robert Bosch GmbH, 70442 Stuttgart (DE)
(72) Erfinder: Purkl, Fabian, 71277 Rutesheim (DE); Roelver, Robert, 75365 Calw-Stammheim (DE)

(57) **Zusammenfassung**

Die Erfindung betrifft ein Verfahren zum Herstellen eines Schichtstapels (100) und/oder eine Topologie. Hierbei wird ein Schichtverbund aus zumindest einer Deckschicht (106) aus einem zweidimensionalen Material, insbesondere wobei die Deckschicht (106) als Sensorschicht ausgebildet ist,und zumindest einer Stützschicht (108) zum Stützen der Deckschicht (106) auf einem Substrat (102) mit einer Vertiefung (104) und/oder einer Erhebung (500) angeordnet. Die Deckschicht (106) weist eine Struktur aus zumindest einem Bauelement (110) auf, insbesondere wobei das Bauelement (110) als Sensorelement ausgebildet ist. Das Bauelement (110) wird der Vertiefung (104) und/oder der Erhebung (500) gegenüberliegend angeordnet. Anschließend wird der Schichtverbund mit einem Druck beaufschlagt, um das Bauelement (110) flächig gegen die Vertiefung (104) und/oder die Erhebung (500) zu drücken, um den Schichtstapel (100) und/oder die Topologie herzustellen.

## Beschreibung

### Stand der Technik

Die Erfindung geht aus von einer Vorrichtung oder einem Verfahren nach Gattung der unabhängigen Ansprüche. Gegenstand der vorliegenden Erfindung ist auch ein Computerprogramm.

Zweidimensionale Materialien versprechen herausragende Eigenschaften für viele Anwendungen in Bereichen wie Elektronik und Sensorik. Insbesondere Graphen ist aufgrund seiner hohen Ladungsträgermobilität bekannt.

Die Herstellung zweidimensionaler Materialien beruht häufig auf der Kombination aus einer Abscheidung auf einem katalytisch wirkendem Ausgangssubstrat und einem darauffolgenden Transfer auf ein Zielsubstrat. Eine bekannte Synthetisierungsmethode ist etwa die Abscheidung mittels chemischer Gasphasenabscheidung.

### Offenbarung der Erfindung

Vor diesem Hintergrund werden mit dem hier vorgestellten Ansatz ein Verfahren zum Herstellen eines Schichtstapels und/oder einer Topologie, ein Schichtstapel, ein Verfahren zum Erfassen eines Magnetfelds, ein Steuergerät, das dieses Verfahren verwendet, sowie schließlich ein entsprechendes Computerprogramm gemäß den Hauptansprüchen vorgestellt. Durch die in den abhängigen Ansprüchen aufgeführten Maßnahmen sind vorteilhafte Weiterbildungen und Verbesserungen der im unabhängigen Anspruch angegebenen Vorrichtung möglich.

Es wird ein Verfahren zum Herstellen eines Schichtstapels und/oder einer Topologie vorgestellt, wobei das Verfahren folgende Schritte umfasst:
Anordnen eines Schichtverbunds aus zumindest einer Deckschicht aus einem zweidimensionalen Material, insbesondere wobei die Deckschicht als Sensorschicht ausgebildet ist, und zumindest einer Stützschicht zum Stützen der Deckschicht auf einem Substrat mit einer Vertiefung und/oder einer Erhebung, wobei die Deckschicht eine Struktur aus zumindest einem Bauelement aufweist, insbesondere wobei das Bauelement als Sensorelement ausgebildet ist, wobei das Bauelement der Vertiefung und/oder der Erhebung gegenüberliegend angeordnet wird; und

Beaufschlagen des Schichtverbunds mit einem Druck, um das Bauelement flächig gegen die Vertiefung und/oder die Erhebung zu drücken, um den Schichtstapel und/oder die Topologie herzustellen.

Unter einem Schichtstapel und/oder einer Topologie kann beispielsweise ein Sensor wie speziell ein Magnetfeldsensor, insbesondere ein Hall-Sensor, verstanden werden. Unter einer Deckschicht aus einem zweidimensionalen Material kann eine Schicht mit der Dicke einer oder zweier Atomlagen verstanden werden. Unter einer Deckschicht kann auch eine Sensorschicht verstanden werden. Je nach Ausführungsform kann der Schichtverbund aus einer oder mehreren übereinandergeschichteten Deckschichten gebildet sein. Bei dem zweidimensionalen Material, kurz 2D-Material, kann es sich beispielsweise um Graphen, Bornitrid, Silicen, Germanan, Stanen oder Phosphoren handeln. Unter einer Stützschicht kann beispielsweise eine Polymerschicht verstanden werden. Bei dem Substrat kann es sich etwa um eine Trägerschicht aus einem Polymer, einem Katalysatormaterial oder einem Halbleitermaterial handeln. Das Substrat kann eine festgelegte Topografie aufweisen, beispielsweise eine pyramidenförmige Aussparung oder Erhebung. Unter einem Bauelement kann ein elektrisch leitfähiger Abschnitt der Deckschicht, etwa in Form einer Hall-Platte, verstanden werden. Unter einem Bauelement kann auch ein Sensorelement verstanden werden.

Der hier vorgestellte Ansatz beruht auf der Erkenntnis, dass eine bereits strukturierte Deckschicht aus einem zweidimensionalen Material wie etwa Graphen mithilfe einer flexiblen Stützschicht auf ein reliefartiges Zielsubstrat aufgebracht werden kann, um einen Sensor Schichtstapel, eine Topologie und/oder einen Sensor herzustellen. Durch einen derartigen Transfer eines zweidimensionalen Materials auf ein Substrat mit Topografie kann das zweidimensionale Material sicher auf das Zielsubstrat übertragen werden. Der Wegfall des nachträglichen Strukturierens der Deckschicht bietet ferner den Vorteil, dass die Anzahl der Herstellungsschritte verringert werden kann.

Gemäß einer Ausführungsform kann im Schritt des Anordnens die Struktur der Deckschicht zumindest ein weiteres Bauelement umfassen. Das Bauelement kann gegenüber einem ersten Oberflächenabschnitt der Vertiefung und/oder der Erhebung angeordnet werden. Das weitere Bauelement kann gegenüber einem zweiten Oberflächenabschnitt der Vertiefung und/oder der Erhebung angeordnet werden. Hierbei können eine Normale des ersten Oberflächenabschnitts und eine Normale des zweiten Oberflächenabschnitts in unterschiedliche Richtungen orientiert sein. Dementsprechend kann im Schritt des Beaufschlagens der Schichtverbund mit dem Druck beaufschlagt werden, um das Bauelement flächig gegen den ersten Oberflächenabschnitt zu drücken und das weitere Bauelement flächig gegen den zweiten Oberflächenabschnitt zu drücken. Unter einem Oberflächenabschnitt kann ein im Wesentlichen ebener Abschnitt einer Oberfläche der Vertiefung und/oder der Erhebung verstanden werden. Durch diese Ausführungsform ist es möglich, einen in mehreren Raumrichtungen sensitiven Sensor bzw. Schichtstapel herzustellen. Beispielsweise können die Bauelemente als Hall-Platten realisiert sein, die sensitiv für senkrecht zur Deckschicht ausgerichtete Magnetfeldkomponenten sind.

Zudem kann das Verfahren einen Schritt des Strukturierens der Stützschicht umfassen. Dadurch können die mechanischen Eigenschaften der Stützschicht gezielt beeinflusst werden.

Gemäß einer Ausführungsform kann die Stützschicht im Schritt des Strukturierens mit zumindest einer Nut strukturiert werden. Die Nut kann entlang einer Biegelinie verlaufen, an der die Stützschicht beim Beaufschlagen umgebogen werden kann. Insbesondere kann im Schritt des Anordnens die Nut gegenüber einer Kante des ersten Oberflächenabschnitts oder, zusätzlich oder alternativ, gegenüber einer Kante des zweiten Oberflächenabschnitts angeordnet werden. Dadurch kann ein Kraftaufwand beim Biegen des Schichtverbunds reduziert werden. Ferner können dadurch Beschädigungen der Stützschicht vermieden werden.

Es ist von Vorteil, wenn im Schritt des Anordnens die Vertiefung durch den Schichtverbund abgedeckt wird, um einen Hohlraum zu bilden. Hierbei kann im Schritt des Beaufschlagens ein Außendruck des Hohlraums erhöht werden. Zusätzlich oder alternativ kann im Schritt des Beaufschlagens ein Innendruck des Hohlraums gesenkt werden, um den Schichtverbund mit dem Druck zu beaufschlagen. Dadurch kann der Schichtverbund möglichst materialschonend mit dem Druck beaufschlagt werden.

Des Weiteren kann der Schichtverbund im Schritt des Beaufschlagens unter Verwendung eines Stempels mit dem Druck beaufschlagt werden. Insbesondere kann eine Kontur des Stempels als Gegenkontur zu einer Kontur der Vertiefung oder, zusätzlich oder alternativ, zu einer Kontur der Erhebung ausgeformt sein. Durch diese Ausführungsform kann der Schichtverbund mechanisch mit dem Druck beaufschlagt werden.

Das Verfahren kann einen Schritt des Entfernens der Stützschicht nach dem Beaufschlagen umfassen. Dadurch kann die Deckschicht nach dem Beaufschlagen freigelegt werden. Somit kann die Effizienz des Schichtstapels und/oder Sensors verbessert werden.

Gemäß einer weiteren Ausführungsform kann im Schritt des Beaufschlagens der Schichtverbund oder, zusätzlich oder alternativ, das Substrat aufgeheizt werden. Dadurch kann die Elastizität des Schichtverbunds erhöht werden.

Gemäß einer vorteilhaften Ausführungsform kann im Schritt des Anordnens ein Schichtverbund aus zumindest zwei Deckschichten und/oder zumindest zwei Stützschichten zum Stützen der zumindest einen Deckschicht angeordnet werden, wobei die zwei Deckschichten und/oder die zumindest zwei Stützschichten aus einem zweidimensionalen Material ausgebildet sind. Auf diese Weise kann ein besonders stabiler und/oder empfindlicher Schichtstapel und/der Sensor hergestellt werden.

Der hier beschriebene Ansatz schafft zudem einen Schichtstapel und/oder Sensor mit folgenden Merkmalen:
einem Substrat mit einer Vertiefung und/oder einer Erhebung; und
einem Schichtverbund aus zumindest einer Deckschicht aus einem zweidimensionalen Material, insbesondere wobei die Deckschicht als Sensorschicht ausgebildet ist, und zumindest einer Stützschicht zum Stützen der Deckschicht, wobei die Deckschicht eine Struktur aus zumindest einem Bauelement aufweist, insbesondere wobei das Bauelement als Sensorelement ausgebildet ist wobei der Schichtverbund derart gegen die Vertiefung und/oder die Erhebung gedrückt ist, dass das Bauelement flächig auf der Vertiefung und/oder Erhebung aufliegt.

Gemäß einer Ausführungsform kann das Bauelement kreuzförmig ausgestaltet sein. Dadurch kann die Sensitivität des Bauelements für ein Magnetfeld erhöht werden.

Gemäß einer weiteren Ausführungsform kann die Vertiefung und/oder die Erhebung zumindest einen ersten Oberflächenabschnitt und einen zweiten Oberflächenabschnitt aufweisen. Eine Normale des ersten Oberflächenabschnitts und eine Normale des zweiten Oberflächenabschnitts können in unterschiedliche Richtungen orientiert sein. Hierbei kann die Struktur der Deckschicht zumindest ein weiteres Bauelement umfassen. Der Schichtverbund kann derart gegen die Vertiefung und/oder die Erhebung gedrückt sein, dass das Bauelement flächig auf dem ersten Oberflächenabschnitt aufliegt und das weitere Bauelement flächig auf dem zweiten Oberflächenabschnitt aufliegt. Durch diese Ausführungsform kann der Erfassungsbereich des Schichtstapels und/oder Sensors vergrößert werden.

Hierbei ist es von Vorteil, wenn die Vertiefung und/oder die Erhebung als Pyramide oder Pyramidenstumpf ausgeformt ist. Dementsprechend kann die Struktur der Deckschicht eine Mehrzahl von Bauelementen umfassen, wobei der Schichtverbund derart gegen die Vertiefung und/oder die Erhebung gedrückt sein kann, dass je eines der Bauelemente flächig auf je einem Wandabschnitt der Pyramide oder des Pyramidenstumpfes aufliegt. Unter einem Wandabschnitt kann etwa eine Seitenfläche oder eine Grundfläche der Pyramide oder des Pyramidenstumpfes oder auch eine Deckfläche des Pyramidenstumpfes verstanden werden. Dadurch kann der Sensor und/oder Schichtstapel unterschiedlich orientierte Magnetfelder erfassen.

Des Weiteren schafft der hier vorgestellte Ansatz ein Verfahren zum Erfassen eines Magnetfelds unter Verwendung eines Schichtstapels und/oder Sensors gemäß einer der vorstehenden Ausführungsformen, wobei das Verfahren folgende Schritte umfasst:
Einlesen eines von dem Schichtstapel erzeugten Signals, das insbesondere als Sensorsignal betrachtet werden kann; und
Ausgeben eines das Magnetfeld repräsentierenden Messwerts unter Verwendung des Signals.

Dieses Verfahren kann beispielsweise in Software oder Hardware oder in einer Mischform aus Software und Hardware, beispielsweise in einem Steuergerät, implementiert sein.

Der hier vorgestellte Ansatz schafft ferner ein Steuergerät, das ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form eines Steuergeräts kann die der Erfindung zugrunde liegende Aufgabe schnell und effizient gelöst werden.

Hierzu kann das Steuergerät zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Steuersignalen an den Aktor und/oder zumindest eine Kommunikationsschnittstelle zum Einlesen oder Ausgeben von Daten aufweisen, die in ein Kommunikationsprotokoll eingebettet sind. Die Recheneinheit kann beispielsweise ein Signalprozessor, ein Mikrocontroller oder dergleichen sein, wobei die Speichereinheit ein Flash-Speicher, ein EPROM oder eine magnetische Speichereinheit sein kann. Die Kommunikationsschnittstelle kann ausgebildet sein, um Daten drahtlos und/oder leitungsgebunden einzulesen oder auszugeben, wobei eine Kommunikationsschnittstelle, die leitungsgebundene Daten einlesen oder ausgeben kann, diese Daten beispielsweise elektrisch oder optisch aus einer entsprechenden Datenübertragungsleitung einlesen oder in eine entsprechende Datenübertragungsleitung ausgeben kann.

Unter einem Steuergerät kann vorliegend ein elektrisches Gerät verstanden werden, das Sensorsignale verarbeitet und in Abhängigkeit davon Steuer- und/oder Datensignale ausgibt. Das Steuergerät kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Ausführungsbeispiele der Erfindung sind in den Zeichnungen dargestellt und in der nachfolgenden Beschreibung näher erläutert. Es zeigt:
Fig. 1 eine schematische Darstellung eines Sensors gemäß einem Ausführungsbeispiel;
Fig. 2 eine schematische Darstellung eines Prozessflusses zur Herstellung eines Sensors gemäß einem Ausführungsbeispiel;
Fig. 3 eine schematische Darstellung zweier Prozessschritte eines Prozessflusses zur Herstellung eines Sensors gemäß einem Ausführungsbeispiel;
Fig. 4 eine schematische Darstellung zweier Prozessschritte eines Prozessflusses zur Herstellung eines Sensors gemäß einem Ausführungsbeispiel;
Fig. 5 eine schematische Darstellung zweier Prozessschritte eines Prozessflusses zur Herstellung eines Sensors gemäß einem Ausführungsbeispiel;
Fig. 6 ein Ablaufdiagramm eines Verfahrens zum Herstellen eines Sensors gemäß einem Ausführungsbeispiel;
Fig. 7 eine schematische Darstellung eines Steuergeräts gemäß einem Ausführungsbeispiel; und
Fig. 8 ein Ablaufdiagramm eines Verfahrens zum Erfassen eines Magnetfelds unter Verwendung eines Sensors gemäß einem Ausführungsbeispiel.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

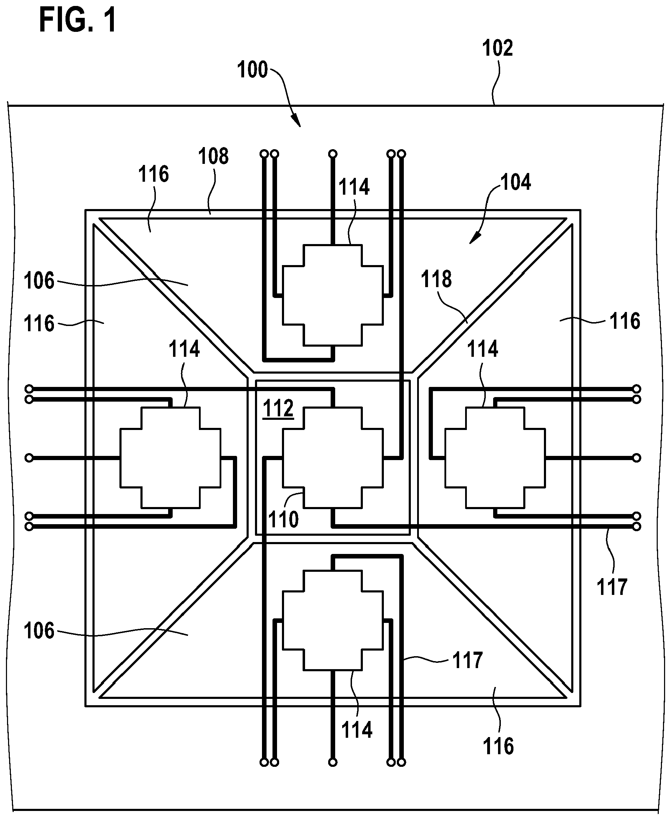

Fig. 1 zeigt eine schematische Darstellung eines Schichtstapels 100 gemäß einem Ausführungsbeispiel in der Draufsicht. Der Schichtstapel 100 kann in der nachfolgenden Beschreibung eines günstigen Ausführungsbeispiels der Erfindung synonym als Sensor bezeichnet werden, obwohl der Schichtstapel 100 prinzipiell auch eine andere Funktion als das Sensieren von physikalischen Größen umfassen kann. Der Sensor 100 umfasst ein Substrat 102 mit einer Vertiefung 104, hier eine Grube in Form eines Pyramidenstumpfes. Gegenüber der Vertiefung 104 ist ein Schichtverbund aus einer strukturierten Deckschicht 106 aus einem zweidimensionalen Material und einer Stützschicht 108 zur mechanischen Stabilisierung der Deckschicht 106 angeordnet. Die Deckschicht 106 kann in der nachfolgenden Beschreibung eines günstigen Ausführungsbeispiels der Erfindung synonym auch als Sensorschicht bezeichnet werden, obwohl die Deckschicht 106 prinzipiell auch eine andere Funktion als das Sensieren von physikalischen Größen umfassen kann. Die Sensorschicht 106 ist mit einem Bauelement 110, hier mit einer Hall-Sensorstruktur in Form eines Hall-Kreuzes, strukturiert. Das Bauelement 110 kann in der nachfolgenden Beschreibung eines günstigen Ausführungsbeispiels der Erfindung synonym als Sensorelement bezeichnet werden, obwohl das Bauelement 110 prinzipiell auch eine andere Funktion als das Sensieren von physikalischen Größen umfassen kann. Der Schichtverbund aus den beiden Schichten 106, 108 ist derart in die Vertiefung 104 gedrückt, dass das Sensorelement 110 flächig auf der Vertiefung 104, etwa auf einer Deckfläche 112 des Pyramidenstumpfes, aufliegt. Die Stützschicht 108 kann auch als Ausgangssubstrat bezeichnet werden. Das Substrat 102 kann auch als Zielsubstrat bezeichnet werden. Bei dem Substrat 102 handelt es sich beispielsweise um einen Siliziumwafer.

Gemäß dem in Fig. 1 gezeigten Ausführungsbeispiel umfasst die Struktur der Sensorschicht 106 zusätzlich zum Sensorelement 110 vier weitere Sensorelemente 114, von denen jedes flächig auf je einer Seitenfläche 116 der pyramidenstumpfförmigen Vertiefung 104 aufliegt. Dadurch, dass sich die vier Seitenflächen 116 sowie die Deckfläche 112 je in eine andere Richtung erstrecken und die fünf Sensorelemente 110, 114 flächig mit den jeweiligen Oberflächenabschnitten der Vertiefung 104 Kontakt haben, sind auch die fünf Sensorelemente 110, 114 je in eine andere Richtung orientiert. Dadurch ist der Sensor 100 in der Lage, Magnetfelder in unterschiedlichen Raumrichtungen zu detektieren.

Jedes der fünf Sensorelemente 110, 114 ist beispielhaft über eine Mehrzahl elektrischer Zuleitungen 117 mit Sensorkontakten elektrisch kontaktiert.

Optional weist die Stützschicht 108 Strukturen in Form von Nuten 118 auf, die mit den Rändern der Vertiefung 104 korrelieren. Die Nuten 118 verlaufen hierbei jeweils entlang einer Biegelinie, an denen die Stützschicht 108 beim Beaufschlagen des Schichtverbunds mit einem Druck, d. h. beim Hineindrücken des Schichtverbunds in die Vertiefung 104, umgebogen wird. Die Strukturen der Stützschicht 108 sind beispielsweise geätzt.

In Fig. 1 ist ein Layout von Strukturen des zweidimensionalen Materials sowie von optionalen Strukturen in der Stützschicht 108 für das Anwendungsbeispiel eines Hall-Magnetfeldsensors gezeigt. Hierbei fällt die Ausrichtung der Sensorelemente 110,114 in Form der Hall-Kreuze in der Vertiefung 104 mit den Strukturen in der Stützschicht 108 zusammen. Der Magnetfeldvektor wird dabei durch Kombination der Sensorsignale der fünf Sensorelemente 110, 114 bestimmt, die fünf verschiedene Orientierungen im Raum aufweisen und somit verschieden sensitiv auf Magnetfelder in beliebigen Raumrichtungen reagieren.

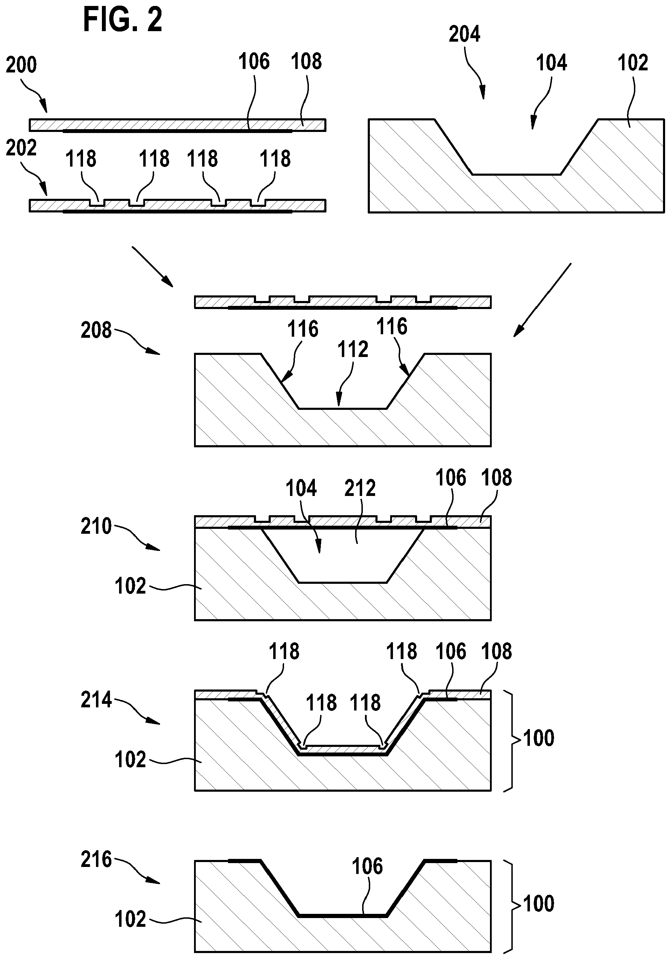

Fig. 2 zeigt eine schematische Darstellung eines Prozessflusses zur Herstellung eines Sensors 100 gemäß einem Ausführungsbeispiel, etwa eines Sensors, wie er vorangehend anhand von Fig. 1 beschrieben ist. Je nach Prozessschritt sind schematische Querschnittdarstellungen des Sensors 100 oder einzelner Komponenten des Sensors 100 gezeigt.

In einem ersten Prozessschritt 200 wird die Sensorsicht 106 aus dem zweidimensionalen Material auf ein flexibles Substrat als Stützschicht 108 aufgebracht, gegebenenfalls strukturiert und mit dieser zu dem Schichtverbund kombiniert. Optional wird die Stützschicht 108 in einem vorangegangenen oder nachfolgenden Prozessschritt 202 zur leichteren Verbiegung strukturiert, beispielsweise mithilfe der Nuten 118. In einem dritten Prozessschritt 204 wird das Substrat 102 mit der gewünschten Topografie angelegt, etwa durch anisotropes Ätzen der Vertiefung 104.

In einem weiteren Prozessschritt 208 werden die jeweiligen Strukturen des Substrats 102 und des Schichtverbunds zueinander ausgerichtet. Beispielsweise wird der Schichtverbund derart angeordnet, dass jede der Nuten 118 je einer Kante eines Oberflächenabschnitts der Vertiefung 104 gegenüberliegt, etwa den Kanten der Seitenflächen 116 und der Deckfläche 112. Wie in Fig. 2 zu erkennen, sind die Seitenflächen 116 jeweils schräg zur Deckfläche 112 ausgerichtet.

Anschließend wird in einem Prozessschritt 210 bei einem Druck P1 und einer Temperatur T1 der Kontakt zwischen dem Schichtverbund und dem Substrat 102 hergestellt. Dabei wird die Vertiefung 104 durch den Schichtverbund abgedeckt, um einen Hohlraum 212 zu bilden, in dem der Druck P1 herrscht. In einem nachfolgenden Prozessschritt 214 wird ein ganzflächiger Kontakt des zweidimensionalen Materials der Sensorschicht 106 mit dem Substrat 102 durch Erhöhung des Außendrucks des Hohlraums 212 auf einen Druck P2, der größer als der Innendruck P1 ist, hergestellt. Zusätzlich wird die Temperatur T1 auf eine Temperatur T2 erhöht. Hierbei wird die Stützschicht 108 gedehnt und an den Nuten 118 umgebogen.

In einem optionalen Prozessschritt 216 wird die Stützschicht 108 von der Sensorschicht 106 entfernt, sodass die Sensorschicht 106 freiliegt.

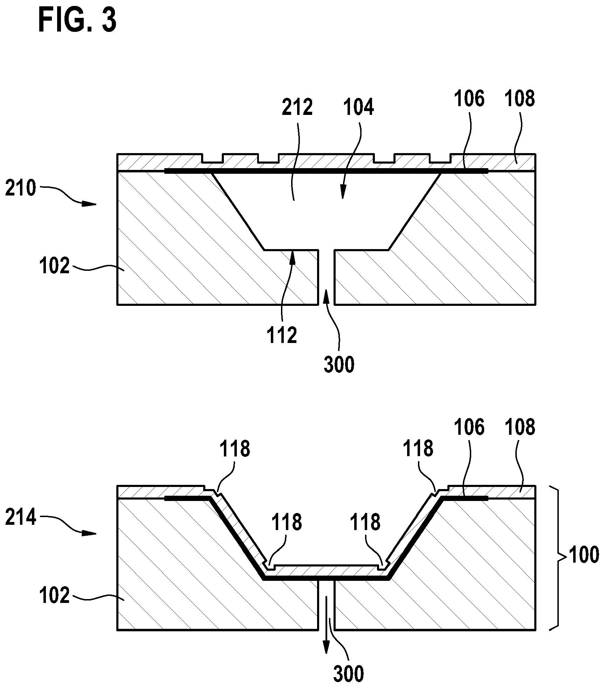

Fig. 3 zeigt eine schematische Darstellung zweier Prozessschritte 210, 214 eines Prozessflusses zur Herstellung eines Sensors 100 gemäß einem Ausführungsbeispiel. Im Unterschied zu Fig. 2 weist das Substrat 102 im Bereich der Deckfläche 112 eine Durchgangsöffnung 300 auf, die den Hohlraum 212 mit einer Außenumgebung des Substrats 102 fluidisch verbindet. Die Durchgangsöffnung 300 fungiert als Druckzugang zum Hohlraum 212, auch Kaverne genannt. Ähnlich wie in Fig. 1 wird im Schritt 210 der Kontakt zwischen dem Substrat 102 und dem Schichtverbund aus der Sensorschicht 106 und der Stützschicht 108 hergestellt, wobei die Sensorschicht 108 der Vertiefung 104 gegenüberliegt.

Im Schritt 214 wird der ganzflächige Kontakt der Sensorschicht 106 mit dem Substrat 102 durch Anlegen eines Differenzdrucks über die Durchgangsöffnung 300 hergestellt. Eine Auslenkungsrichtung des Schichtverbunds ist mit einem Pfeil gekennzeichnet. Hierbei wird der innerhalb des Hohlraums 212 herrschende Druck P1, der beispielsweise dem Atmosphärendruck entspricht, auf einen Druck P2 reduziert.

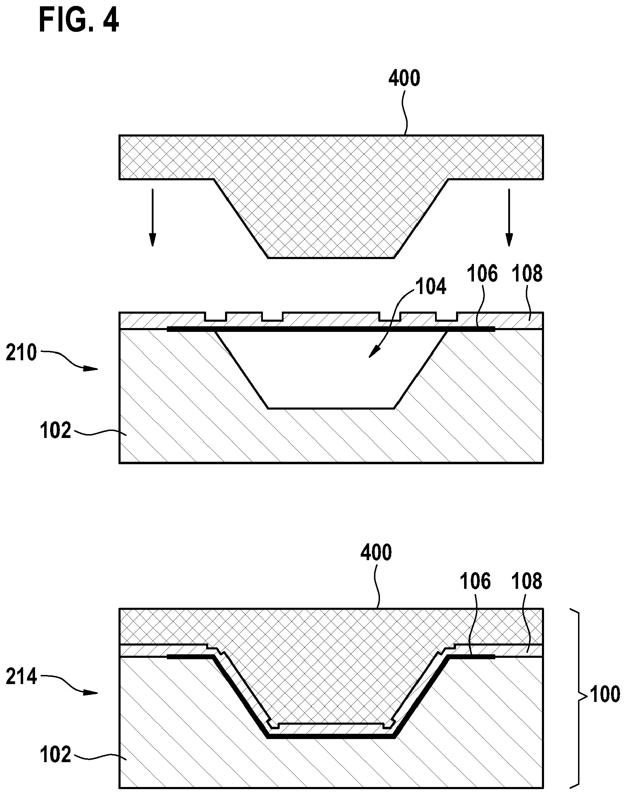

Fig. 4 zeigt eine schematische Darstellung zweier Prozessschritte 210, 214 eines Prozessflusses zur Herstellung eines Sensors 100 gemäß einem Ausführungsbeispiel. Im Unterschied zu dem vorangehend anhand der Figuren 2 und 3 beschriebenen Prozessfluss wird gemäß dem in Fig. 4 gezeigten Ausführungsbeispiel ein Stempel 400 verwendet, um die Anpassung des Schichtverbunds an die Topografie des Substrats 102 zu erreichen. Der Stempel 400 weist eine Kontur auf, die im Wesentlichen als eine Gegenkontur zu einer Kontur der Vertiefung 104, d. h. zu einer Kontur des Pyramidenstumpfes, ausgestaltet ist.

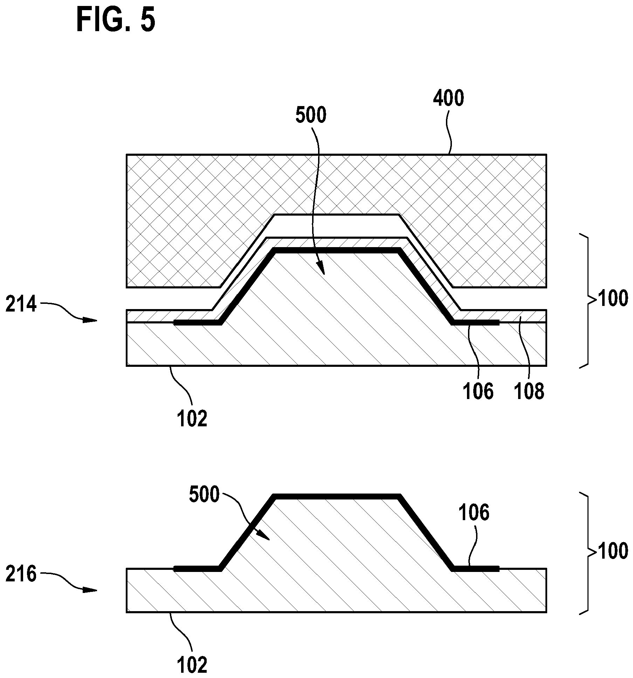

Fig. 5 zeigt eine schematische Darstellung zweier Prozessschritte 214, 216 eines Prozessflusses zur Herstellung eines Sensors 100 gemäß einem Ausführungsbeispiel. Im Unterschied zu dem vorangehend anhand der Figuren 2 bis 4 beschriebenen Prozessfluss ist das Substrat 102 nicht mit einer Vertiefung, sondern mit einer Erhebung 500 ausgeformt, hier beispielhaft ebenfalls in Form eines Pyramidenstumpfes. Zum Beaufschlagen des Schichtverbunds mit Druck dient wiederum der Stempel 400, der mit einer der Kontur der Erhebung 500 entsprechenden Gegenkontur ausgeformt ist. Zusätzlich zum Transfer der Sensorschicht 106 auf die Seitenwände von Gräben im Substrat 102 ist damit auch der Transfer auf erhabene Strukturen möglich.

Im Prozessschritt 216 wird die Stützschicht 108 wiederum durch Entfernen der Stützschicht 108 freigelegt.

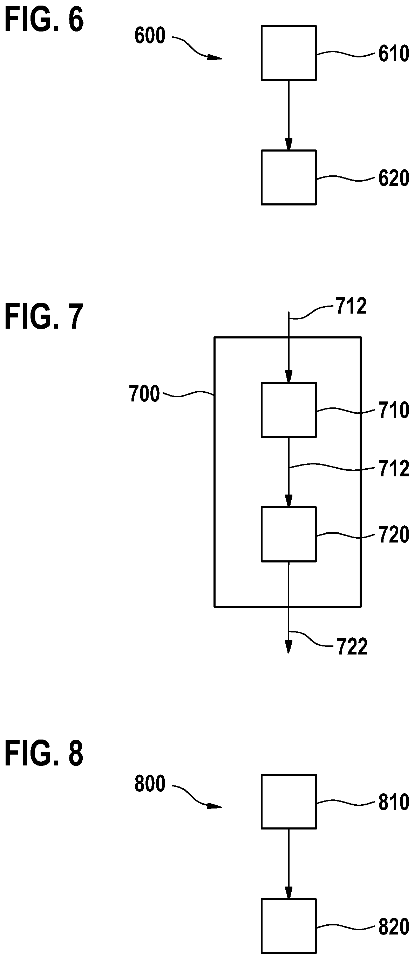

Fig. 6 zeigt ein Ablaufdiagramm eines Verfahrens 600 zum Herstellen eines Sensors gemäß einem Ausführungsbeispiel, etwa eines Sensors, wie er vorangehend anhand der Figuren 1 bis 5 beschrieben ist. Das Verfahren 600 startet mit einem Schritt 610, in dem der Schichtverbund auf dem Substrat angeordnet wird. Das Anordnen erfolgt derart, dass das Sensorelement der Vertiefung oder der Erhebung im Substrat gegenüberliegt. Der Schritt 610 umfasst beispielsweise die vorangehend anhand von Fig. 2 beschriebenen Prozessschritte 208, 210 als Teilschritte.

In einem weiteren Schritt 620 wird der auf dem Substrat angeordnete Schichtverbund mit einem Druck beaufschlagt, etwa mechanisch mittels eines Stempels oder pneumatisch durch Anlegen einer Druckdifferenz. Hierbei wird das Sensorelement flächig gegen eine Oberfläche der Vertiefung bzw. der Erhebung gedrückt. Der Schritt 620 umfasst beispielsweise den vorangehend anhand der Figuren 2 bis 5 beschriebenen Prozessschritt 214.

Fig. 7 zeigt eine schematische Darstellung eines Steuergeräts 700 gemäß einem Ausführungsbeispiel. Das Steuergerät 700 dient beispielsweise zum Erfassen eines Magnetfelds unter Verwendung eines Sensors, wie er vorangehend anhand der Figuren 1 bis 6 beschrieben ist. Das Steuergerät 700 umfasst eine Einleseeinheit 710 zum Einlesen eines von dem Sensor erzeugten Sensorsignals 712. Eine Ausgabeeinheit 720 des Steuergeräts 700 ist ausgebildet, um unter Verwendung des Sensorsignals 712 einen das Magnetfeld repräsentierenden Messwert 722 auszugeben.

Fig. 8 zeigt ein Ablaufdiagramm eines Verfahrens 800 zum Erfassen eines Magnetfelds unter Verwendung eines Sensors gemäß einem Ausführungsbeispiel. Das Verfahren 700 kann etwa im Zusammenhang mit einem vorangehend anhand von Fig. 7 beschriebenen Steuergerät durchgeführt werden. Hierbei wird in einem Schritt 810 das Sensorsignal eingelesen. In einem Schritt 820 wird unter Verwendung des Sensorsignals der das Magnetfeld repräsentierende Messwert ausgegeben.

Nachfolgend wird der hier beschriebene Ansatz anhand der Figuren 1 bis 8 nochmals mit anderen Worten zusammengefasst.

Der Ansatz schafft eine Methode, um 2D-Materialien und Schichtstapel aus 2D-Materialien auf Substrate mit vorher festgelegter Topografie, auch Zielsubstrate genannt, zu transferieren. Über die Definition dieser Topografie ist es möglich, 2D-Material-Schichten mit verschiedenen Orientierungen im Raum zu realisieren.

Dadurch wird etwa die Herstellung eines 3D-Magnetfeldsensors basierend auf Graphen ermöglicht, der gegenüber herkömmlichen Hall-Sensoren eine deutlich verbesserte Magnetfeldsensitivität aufweist. Der Vorteil der Integration verschieden ausgerichteter Hall-Sensorschichten auf einem Substrat ist eine deutlich kostengünstigere Herstellung, eine geringere Baugröße und eine genauere Einstellung des Winkels zwischen verschiedenen Ebenen.

Als Ausgangspunkt dient je nach Ausführungsbeispiel eine ein- oder mehrlagige Graphenschicht als Sensorschicht 106, die sich entweder durch direktes Abscheiden oder als Ergebnis eines Transferprozesses auf einem flexiblen Substrat, beispielsweise aus Polymethylmethacrylat (PMMA), Polyimid (PI) oder Polycarbonat (PC), vorangehend auch Stützschicht 108 genannt, befindet und mit dieser zu dem Schichtverbund kombiniert ist. Eine Abfolge entsprechender Prozessschritte ist schematisch in Fig. 2 gezeigt.

Je nach Ausführungsbeispiel werden alternativ zu einer Graphenschicht auch andere 2D-Materialien wie MoS2, WS2 oder Black Phosphorus oder Stapel aus mehreren 2D-Materialien verwendet. Eine vorteilhafte Ausführung für Magnetfeldsensoren ist beispielsweise ein symmetrischer Stapel aus hexagonalem BN (h-BN) und Graphen: h-BN/Graphen/h-BN. Hierbei ist das Graphen bereits während des gesamten Transferprozesses vor den verwendeten Chemikalien und vor weiteren äußeren Einflüssen geschützt und passiviert.

Das 2D-Material kann bereits auf dem flexiblen Ausgangssubstrat in der gewünschten Geometrie vorliegen, indem es entweder durch Ätzen strukturiert wurde oder zuvor nur an den gewünschten Stellen selektiv abgeschieden wurde. Somit wird eine Strukturierung nach dem Transfer auf der Topografie des Zielsubstrats vermieden. Ein Beispiel für die Strukturierung einer Sensorschicht mit Sensorelementen in Form von Hall-Elementen für einen Magnetfeldsensor ist in Fig. 1 gezeigt.

Die elektrischen Zuleitungen 117 zu den Sensorelementen 110, 114 sind optional ebenfalls aus Graphen realisiert. Der Vorteil ist hierbei die Flexibilität des Graphens, die ein Biegen über Kanten ohne Bruch oder Risse erlaubt.

Um die Verbiegung und Anpassung des Schichtverbunds aus der Sensorschicht 106 und der Stützschicht 108 an die Topografie des Substrats 102 zu erleichtern, werden etwa durch Ätzen oder Laserstrukturieren flexiblere Stellen ein- oder beidseitig in der Stützschicht 108 angelegt. Dieser zusätzliche Schritt hilft, die auftretenden mechanischen Spannungen in der Stützschicht 108 oder in der Sensorschicht 106 während des Transfers und nach dem Transfer zu minimieren.

Das Substrat 102 ist so hergestellt, dass es Oberflächen mit der für die Zielanwendung gewünschten Orientierung im Raum besitzt. Der Winkel zur Oberfläche sollte so begrenzt sein, dass ein Kontakt mit der Sensorschicht 106 während des Transfers noch möglich ist. Hierzu wird beispielsweise ein Winkel kleiner 70 Grad gewählt.

Gemäß einem Ausführungsbeispiel wird das Substrat 102 durch anisotropes Ätzen von Silizium mit Kaliumhydroxid (KOH) hergestellt, um einen pyramidenförmigen Graben als Vertiefung 104 zu erzeugen. Der Vorteil dieser Methode ist, dass der Winkel, beispielsweise 54,7 Grad bei {100}-orientierten Wafern, zwischen Oberfläche und Seitenwänden genau bestimmt ist. Die Topografie, d. h. die maximale Vertiefung oder Erhöhung zur Oberfläche, liegt hierbei im Bereich von 10 bis 200 µm und ist durch die Dicke des Substrats 102 beschränkt.

Die Sensorschicht 106 auf der Stützschicht 108 wird im Prozessschritt 208 beispielsweise über optische Markerstrukturen am Substrat 102 ausgerichtet. Daraufhin werden der Schichtverbund und das Substrat 102 in den Prozessschritten 210, 214 in Kontakt gebracht. Der Kontakt kann durch eine erhöhte Anpresskraft, eine erhöhte Temperatur und durch das Anlegen einer elektrischen Spannung zwischen den beiden Komponenten verbessert werden.

Die Sensorschicht 106 und die Stützschicht 108 werden je nach Ausführungsbeispiel folgendermaßen an die Topografie des Substrats 102 angepasst.

Beispielsweise werden der Schichtverbund und das Substrat 102 bei reduziertem Druck oder im Vakuum in Kontakt gebracht. Daraufhin wird die Prozesskammer belüftet oder ein Überdruck angelegt. Die Druckdifferenz zwischen dem durch die flexible Stützschicht 108 abgeschlossenen Hohlraum 212 und der Umgebung sorgt für eine Anpassung der Stützschicht 108 und somit für ein flächiges Anliegen der Sensorschicht 106 auf den Oberflächen des Substrats 102.

Alternativ wird der Differenzdruck dadurch erzeugt, dass zuvor ein Zugang in Form der Durchgangsöffnung 300 von der Rückseite in die Vertiefung 104 angelegt wird, etwa durch Ätzen mit DRIE von der Rückseite des Substrats 102. Durch Anlegen eines Unterdrucks an diesen Zugang wird die Sensorschicht 106 wie zuvor flächig in Kontakt gebracht.

Alternativ wird der flächige Kontakt mithilfe des Stempels 400 durch Anpressen hergestellt.

Es sind auch Kombinationen der genannten Ausführungsbeispiele möglich.

Der Übertrag der Sensorschicht 106 auf die Seitenwände einer erhabenen Struktur wie der in Fig. 5 gezeigten Erhebung 500 ist ebenfalls möglich. Um das Anpassen der beiden Schichten 106, 108 an die Topografie des Substrats 102 zu erleichtern, kann auch in diesem Fall eine erhöhte Temperatur angelegt werden, wenn nötig bis über die Glasübergangstemperatur der Stützschicht 108.

Nach dem Transfer auf das Substrat 102 wird die Stützschicht 108 im Prozessschritt 216 beispielsweise durch nass- oder trockenchemisches Ätzen bei Bedarf entfernt. Zusätzlich können weitere Prozessschritte wie beispielsweise die elektrische Kontaktierung der Sensorschicht 106 durchgeführt werden.

Für das Anwendungsbeispiel eines Hall-Sensors 100 aus Graphen kann aus den Sensorsignalen der in verschiedenen Raumrichtungen auf den Seitenwänden realisierten Sensorelemente der Vektor des Magnetfelds, d. h. dessen Größe und Richtung, bestimmt werden. Wird der Sensor 100 mit mehr als einem Sensorelement je Raumrichtung realisiert, können die zusätzlichen Sensorsignale etwa zur Fehlerkorrektur verwendet werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (600) zum Herstellen eines Schichtstapels (100) und/oder einer Topografie, wobei das Verfahren (600) folgende Schritte umfasst:
Anordnen (610) eines Schichtverbunds aus zumindest einer Deckschicht (106) aus einem zweidimensionalen Material, insbesondere wobei die Deckschicht (106) als Sensorschicht ausgebildet ist, und zumindest einer Stützschicht (108) zum Stützen der Deckschicht (106) auf einem Substrat (102) mit einer Vertiefung (104) und/oder einer Erhebung (500), wobei die Deckschicht (106) eine Struktur aus zumindest einem Bauelement (110) aufweist, insbesondere wobei das Bauelement (110) als Sensorelement ausgebildet ist, wobei das Bauelement (110) der Vertiefung (104) und/oder der Erhebung (500) gegenüberliegend angeordnet wird; und
Beaufschlagen (620) des Schichtverbunds mit einem Druck, um das Bauelement (110) flächig gegen die Vertiefung (104) und/oder die Erhebung (500) zu drücken, um den Schichtstapel (100) und/oder die Topologie herzustellen.

2. Verfahren (600) gemäß Anspruch 1, **dadurch gekennzeichnet, dass** im Schritt des Anordnens (610) die Struktur der Deckschicht (106) zumindest ein weiteres Bauelement (114) umfasst, wobei das Bauelement (110) gegenüber einem ersten Oberflächenabschnitt (112) der Vertiefung (104) und/oder der Erhebung (500) angeordnet wird und das weitere Bauelement (114) gegenüber einem zweiten Oberflächenabschnitt (116) der Vertiefung (104) und/oder der Erhebung (500) angeordnet wird, wobei eine Normale des ersten Oberflächenabschnitts (112) und eine Normale des zweiten Oberflächenabschnitts (116) in unterschiedliche Richtungen orientiert sind, wobei im Schritt des Beaufschlagens (620) der Schichtverbund mit dem Druck beaufschlagt wird, um das Bauelement (110) flächig gegen den ersten Oberflächenabschnitt (112) zu drücken und das weitere Bauelement (114) flächig gegen den zweiten Oberflächenabschnitt (116) zu drücken.

3. Verfahren (600) gemäß einem der vorangegangenen Ansprüche, **gekennzeichnet durch** einen Schritt des Strukturierens (202) der Stützschicht (108).

4. Verfahren (600) gemäß Anspruch 3, **dadurch gekennzeichnet, dass** im Schritt des Strukturierens (202) die Stützschicht (108) mit zumindest einer Nut (118) strukturiert wird, wobei die Nut (118) entlang einer Biegelinie verläuft, an der die Stützschicht (108) beim Beaufschlagen (620) umgebogen wird, insbesondere wobei im Schritt des Anordnens (610) die Nut (118) gegenüber einer Kante des ersten Oberflächenabschnitts (112) und/oder des zweiten Oberflächenabschnitts (116) angeordnet wird.

5. Verfahren (600) gemäß einem der vorangegangenen Ansprüche, **dadurch gekennzeichnet, dass** im Schritt des Anordnens (610) die Vertiefung (104) durch den Schichtverbund abgedeckt wird, um einen Hohlraum (212) zu bilden, wobei im Schritt des Beaufschlagens (620) ein Außendruck des Hohlraums (212) erhöht wird und/oder ein Innendruck des Hohlraums (212) gesenkt wird, um den Schichtverbund mit dem Druck zu beaufschlagen.

6. Verfahren (600) gemäß einem der vorangegangenen Ansprüche, **dadurch gekennzeichnet, dass** im Schritt des Beaufschlagens (620) der Schichtverbund unter Verwendung eines Stempels (400) mit dem Druck beaufschlagt wird, insbesondere wobei eine Kontur des Stempels (400) als Gegenkontur zu einer Kontur der Vertiefung (104) und/oder der Erhebung (500) ausgeformt ist und/oder **dadurch gekennzeichnet, dass** im Schritt des Beaufschlagens (620) der Schichtverbund und/oder das Substrat (102) aufgeheizt wird.

7. Verfahren (600) gemäß einem der vorangegangenen Ansprüche, **gekennzeichnet durch** einen Schritt des Entfernens (216) der Stützschicht (108) nach dem Beaufschlagen (620).

8. Verfahren (600) gemäß einem der vorangegangenen Ansprüche, **dadurch gekennzeichnet, dass** im Schritt des Anordnens (610) ein Schichtverbund aus zumindest zwei Deckschichten (106) und/oder zumindest zwei Stützschichten (108) zum Stützen der zumindest einen Deckschicht (106) angeordnet wird, wobei die zwei Deckschichten (106) und/oder die zumindest zwei Stützschichten (108) aus einem zweidimensionalen Material ausgebildet sind.

9. Schichtstapel (100) mit folgenden Merkmalen:
einem Substrat (102) mit einer Vertiefung (104) und/oder einer Erhebung (500); und
einem Schichtverbund aus zumindest einer Deckschicht (106) aus einem zweidimensionalen Material, insbesondere wobei die Deckschicht (106) als Sensorschicht ausgebildet ist, und zumindest einer Stützschicht (108) zum Stützen der Deckschicht (106), wobei die Deckschicht (106) eine Struktur aus zumindest einem Bauelement (110) aufweist, insbesondere wobei das Bauelement (110) als Sensorelement ausgebildet ist wobei der Schichtverbund derart gegen die Vertiefung (104) und/oder die Erhebung (500) gedrückt ist, dass das Bauelement (110) flächig auf der Vertiefung (104) und/oder Erhebung (500) aufliegt.

10. Schichtstapel (100) gemäß Anspruch 9, **dadurch gekennzeichnet, dass** das Bauelement (110) kreuzförmig ausgestaltet ist.

11. Schichtstapel (100) gemäß Anspruch 9 oder 10, **dadurch gekennzeichnet, dass** die Vertiefung (104) und/oder die Erhebung (500) zumindest einen ersten Oberflächenabschnitt (112) und einen zweiten Oberflächenabschnitt (116) aufweist, wobei eine Normale des ersten Oberflächenabschnitts (112) und eine Normale des zweiten Oberflächenabschnitts (116) in unterschiedliche Richtungen orientiert sind, wobei die Struktur der Deckschicht (106) zumindest ein weiteres Bauelement (114) umfasst, wobei der Schichtverbund derart gegen die Vertiefung (104) und/oder die Erhebung (500) gedrückt ist, dass das Bauelement (110) flächig auf dem ersten Oberflächenabschnitt (112) aufliegt und das weitere Bauelement (114) flächig auf dem zweiten Oberflächenabschnitt (116) aufliegt.

12. Schichtstapel (100) gemäß Anspruch 9 oder 10, **dadurch gekennzeichnet, dass** die Vertiefung (104) und/oder die Erhebung (500) als Pyramide oder Pyramidenstumpf ausgeformt ist, wobei die Struktur der Deckschicht (106) eine Mehrzahl von Bauelementen (110, 114) umfasst, wobei der Schichtverbund derart gegen die Vertiefung (104) und/oder die Erhebung (500) gedrückt ist, dass je eines der Bauelemente (110, 114) flächig auf je einem Wandabschnitt (112, 116) der Pyramide oder des Pyramidenstumpfes aufliegt.

13. Verfahren (800) zum Erfassen eines Magnetfelds unter Verwendung eines Schichtstapel (100) gemäß einem der Ansprüche 9 bis 12, der als Sensor verwendet wird, wobei das Verfahren (800) folgende Schritte umfasst:
Einlesen (810) eines von dem Schichtstapel (100) erzeugten Signals (712); und
Ausgeben (820) eines das Magnetfeld repräsentierenden Messwerts (722) unter Verwendung des Signals (712).

14. Steuergerät mit Einheiten (710, 720), die ausgebildet sind, um das Verfahren (800) gemäß Anspruch 13 auszuführen und/oder anzusteuern.

15. Computerprogramm, das ausgebildet ist, um das Verfahren (800) gemäß Anspruch 13 auszuführen und/oder anzusteuern.
